# FASCICULE DE BREVET EUROPEEN

(11) **EP 4 423 558 B1**
(45) Date de publication et mention de la délivrance du brevet: **27.08.2025**
(21) Numéro de dépôt: 22813665.1
(22) Date de dépôt: 28.10.2022
(51) Int. Cl.: H05K 9/00, G02B 26/00, G01J 5/06, G01J 1/04, G01J 1/42

(54) **ECRAN DE BLINDAGE ELECTROMAGNETIQUE AUTO-ADAPTATIF A COUCHES MINCES**
SELBSTANPASSENDER ELEKTROMAGNETISCHER DÜNNSCHICHT-ABSCHIRMUNGSSCHIRM
SELF-ADAPTIVE THIN-FILM ELECTROMAGNETIC SHIELDING SCREEN

(30) Priorité: 28.10.2021 FR 2111517
(43) Date de publication de la demande: 04.09.2024
(73) Titulaire: Centre National de la Recherche Scientifique, 75794 Paris Cedex 16 (FR); Université de Rennes, 35065 Rennes Cedex (FR); Safran Electronics & Defense, 75015 Paris (FR)
(72) Inventeur: TRICAS, Quentin, 77550 MOISSY-CRAMAYEL (FR); FOUTREL, Patrice, 77550 MOISSY-CRAMAYEL (FR); CASTEL, Xavier, 35000 RENNES (FR); LE PAVEN, Claire, 35000 RENNES (FR); BESNIER, Philippe, 75016 PARIS (FR)
(74) Mandataire: Ernest Gutmann - Yves Plasseraud S.A.S.
(86) Numéro de dépôt international: PCT/FR2022/052048
(87) Numéro de publication internationale: WO 2023/073327

(56) Documents cités:
- WO-A1-2018/215243
- WO-A1-2022/018346
- JP-A- 2001 210 990

## Description

### Domaine technique

La présente divulgation relève du domaine des écrans de blindage électromagnétiques optiquement transparents à maillage conducteur électrique auto-adaptatifs pour des systèmes de capteurs électromagnétiques et/ou optiques à protéger de rayonnements électromagnétiques intenses. Dans les écrans de blindage optiquement transparents à maillage conducteur électrique auto-adaptatifs, le maillage est mis à la masse d'un boîtier renfermant au moins un capteur lorsqu'un champ électromagnétique dépassant un certain seuil critique pour le fonctionnement optimal du dit capteur est perçu par un organe de protection.

### Technique antérieure

Les écrans de blindage en protection des agressions électromagnétiques (EM) externes ont pour objectif principal de protéger les équipements optroniques équipant des véhicules et leurs capteurs optiques tout en assurant une transparence optique élevée dans les domaines de l'UV (ultraviolet), du visible et de l'IR (infrarouge) pour un fonctionnement optimal desdits équipements optroniques et capteurs optiques associés. Ces écrans, à ce jour, présentent une valeur prédéfinie et constante d'efficacité de blindage, déterminée par les paramètres intrinsèques d'un blindage RF réalisé par un maillage métallique à pas micrométrique de l'écran raccordé à une masse de l'équipement.

Pour ce qui concerne les blindages RF commutables à maillages électriquement conducteurs, le document WO2018/215243 A1 au nom des demanderesses propose un écran de blindage à maillage électriquement conducteur à pas micrométrique directement imprimé sur une face interne d'optiques ou de hublots (en silicium, germanium, saphir, verre B, etc.) de différents équipements optroniques. Le maillage électriquement conducteur à pas micrométrique est défini par la largeur de ses rubans constitutifs électriquement conducteurs, typiquement de l'ordre de 10 micromètres, son pas de maillage ou bien période, typiquement de l'ordre de 100 micromètres et l'épaisseur du matériau électriquement conducteur utilisé, typiquement de l'ordre de 2 micromètres. La modulation de l'efficacité de blindage (EB) est obtenue par le contrôle de la valeur de l'impédance de contact entre ce maillage électriquement conducteur et un retour de masse de l'écran de blindage. Ce contrôle est réalisé, soit par l'implantation de composants localisés tels que diodes PIN, MEMS, NEMS ou autres entre le maillage électriquement conducteur et le retour de masse ; soit par l'utilisation de rubans imprimés à base de matériaux à transition isolant-métal, typiquement VO₂ dont les deux états ON (conducteur électrique) et OFF (isolant électrique) modifient fortement la valeur de l'impédance de contact de l'écran avec la masse, et en conséquence, la valeur de l'EB de l'écran, et ce de manière totalement réversible.

Cette première solution nécessite une commande pour activer la variation de l'impédance de contact du blindage et une alimentation électrique préférablement externe au dispositif à protéger.

Par ailleurs, la demande FR21 02339 déposée le 10 mars 2021 par les demanderesses décrit une solution technique consistant à capter l'énergie d'une agression EM externe via une antenne redresseuse, et à utiliser le courant continu généré pour activer les composants localisés tels que diodes PIN, MEMS, NEMS ou autres, ou encore les rubans imprimés à base de matériaux à transition isolant-métal, typiquement VO₂, ou bien encore actionner une micropompe injectant un liquide dans un canal entre le blindage RF et la masse, afin d'adapter dynamiquement la valeur de l'EB de l'écran de blindage, et rendre ainsi le blindage RF commutable. Le système complet devient donc un écran de blindage à efficacité de blindage (EB) contrôlée, dont la valeur de l'EB augmente automatiquement dès l'apparition de l'agression électromagnétique (EM) externe, sans besoin d'une activation du système par un opérateur. Cette solution ne nécessite pas d'alimentation mais est efficace pour des énergies EM reçues élevées, notamment si les moyens de mise à la masse du blindage nécessitent un courant ou une tension élevés pour leur activation.

### Résumé

La présente divulgation vise à rendre encore plus aisé la réalisation d'un dispositif de blindage électromagnétique auto-adaptatif pour la protection d'un équipement renfermant un capteur opto-électronique et propose un dispositif de blindage électromagnétique auto-adaptatif optiquement transparent d'une optique ou d'un hublot d'un équipement pourvu d'une enceinte électriquement conductrice renfermant au moins un capteur optique ou RF derrière ladite optique ou ledit hublot, ledit dispositif comportant sur au moins une face de ladite optique ou dudit hublot un écran de blindage comportant un maillage de blindage RF commutable au moins partiellement entouré par une bordure de matériau à transition isolant-métal disposée entre ledit maillage et un entourage électriquement conducteur de blindage dudit équipement, comportant un élément suscepteur, disposé en regard du ou en contact avec ledit matériau à transition isolant-métal et adapté à transformer une énergie électromagnétique incidente en quantité de chaleur d'activation dudit matériau à transition isolant-métal, ledit élément suscepteur étant dimensionné pour provoquer un passage à l'état conducteur dudit matériau à transition isolant-métal sous l'action de ladite énergie électromagnétique en sorte de relier électriquement à basse impédance ledit maillage audit entourage électriquement conducteur lorsque l'énergie électromagnétique incidente dépasse un seuil donné.

Ceci permet une transition automatique du blindage auto adaptatif depuis une configuration laissant passer les ondes électromagnétiques à une configuration de blindage bloquant lesdites ondes à partir d'une énergie électromagnétique incidente donnée.

Le maillage de blindage RF est préférablement à pas micrométrique pour un blindage actif sur des fréquences de plusieurs GHz à plusieurs dizaines de GHz.

Les caractéristiques exposées dans les paragraphes suivants peuvent, optionnellement, être mises en oeuvre, indépendamment les unes des autres ou en combinaison les unes avec les autres :

Selon un premier mode de réalisation, le maillage de blindage RF commutable et le matériau à transition isolant-métal sont disposés sur une face de ladite optique ou dudit hublot interne à l'équipement tandis que l'élément suscepteur est réalisé sur une face externe de ladite optique ou dudit hublot et comporte une couche de matériau électriquement conducteur en regard d'une surface dudit matériau à transition isolant-métal.

Le matériau à transition isolant-métal peut former un premier cadre autour du maillage, l'élément suscepteur étant conformé en second cadre en regard dudit premier cadre.

Dans ce cas, une surface du second cadre peut être supérieure ou égale à une surface du premier cadre.

L'élément suscepteur peut comporter une couche de matériau conducteur semi-transparente recouvrant la face externe de ladite optique ou dudit hublot.

Selon un second mode de réalisation, le maillage de blindage RF commutable et le matériau à transition isolant-métal sont déposés sur une face externe de ladite optique ou dudit hublot, l'élément suscepteur comportant une couche de matériau conducteur en regard d'une surface dudit matériau à transition isolant-métal et déposée sur une couche électriquement isolante recouvrant ledit matériau à transition isolant-métal.

Selon un troisième mode de réalisation, le maillage de blindage RF commutable, le matériau à transition isolant-métal et l'élément suscepteur sont disposés sur une face de ladite optique ou dudit hublot interne ou externe à l'équipement, l'élément suscepteur étant réalisé sous la forme d'un cadre entourant le matériau à transition isolant-métal, ce dernier entourant le maillage de blindage RF commutable.

Selon un quatrième mode de réalisation, le maillage de blindage RF commutable et le cadre en matériau à transition isolant-métal sont déposés sur une face externe de ladite optique ou dudit hublot, l'élément suscepteur comportant une couche de matériau conducteur, en regard d'une surface dudit matériau à transition isolant-métal, déposée sur une couche électriquement isolante recouvrant elle-même ledit matériau à transition isolant-métal. Le maillage de blindage RF commutable peut en particulier être réalisé en matériau à transition isolant-métal déposé sur une face externe de ladite optique ou dudit hublot et recouvrant ladite face externe, l'élément suscepteur comportant une couche de matériau conducteur déposé sur une couche isolante et la recouvrant, ladite couche isolante recouvrant elle-même ledit matériau à transition isolant-métal.

Ladite couche de matériau conducteur et/ou ladite couche de matériau isolant peuvent dans ce cas comporter un maillage optiquement transparent recouvrant le maillage de blindage RF commutable, en particulier dans la zone de la lentille ou du hublot face au capteur du système à protéger.

Pour l'ensemble des solutions, le maillage de blindage RF commutable peut être un maillage à pas micrométrique en matériau électriquement conducteur, la structuration du maillage pouvant être périodique ou bien apériodique (de type Voronoï).

Le maillage à pas micrométrique peut être en matériau choisi parmi un bicouche titane/argent, un matériau à transition isolant-métal ou l'or.

Le matériau à transition isolant-métal peut être un matériau de type VO₂ d'épaisseur entre 1000 nm et 2000 nm.

L'élément suscepteur peut être un film d'or d'épaisseur de 2 nanomètres à 10 nanomètres.

Le maillage de blindage RF commutable est avantageusement dimensionné pour fournir une efficacité de blindage de 10 dB à 40 dB dans une bande de fréquence de 0,1 GHz à 40 GHz lorsqu'il est raccordé électriquement à basse impédance à l'entourage conducteur électrique par le matériau à transition isolant-métal rendu électriquement conducteur.

La transparence optique de l'écran de blindage est d'au moins 50% dans le domaine du visible que le blindage soit actif ou inactif.

### Brève description des dessins

D'autres caractéristiques, détails et avantages apparaîtront à la lecture de la description détaillée ci-après, et à l'analyse des dessins annexés, sur lesquels :
[Fig. 1A] montre une vue de dessus d'un premier exemple de réalisation de blindage auto-adaptatif de la présente divulgation ;
[Fig. 1B] montre une vue de dessous du premier exemple de réalisation de blindage auto-adaptatif de la présente divulgation ;
[Fig. 1C] une vue de dessus d'une variante de la figure 1A ;
[Fig. 2] montre une vue schématique d'un dispositif à capteur derrière un hublot comportant un blindage auto-adaptatif sous faible contrainte électromagnétique ;
[Fig. 3] montre une vue schématique du dispositif de la figure 2 sous forte contrainte électromagnétique de la présente divulgation ;
[Fig. 4A] une vue de dessus d'un deuxième exemple de réalisation de blindage auto-adaptatif de la présente divulgation ;
[Fig. 4B] une vue de dessous de l'exemple de réalisation de blindage auto-adaptatif de la figure 4A ;
[Fig. 4C] une vue de dessus d'une variante de blindage auto-adaptatif de la figure 4A ;
[Fig. 5A] une vue de dessus d'un troisième exemple de réalisation de blindage auto-adaptatif de la présente divulgation ;
[Fig. 5B] une vue de dessous de l'exemple de réalisation de blindage auto-adaptatif de la figure 5A ;
[Fig. 6A] une vue de côté d'un quatrième exemple de réalisation de blindage auto-adaptatif de la présente divulgation ;
[Fig. 6B] une vue de côté d'une variante du blindage auto-adaptatif de la figure 6A.

### Description des modes de réalisation.

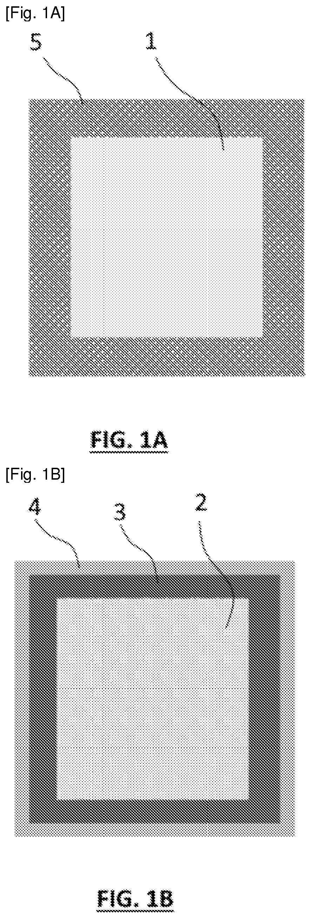

L'objectif de la présente divulgation est de réaliser un écran de blindage électromagnétique auto-adaptatif optiquement transparent, c'est-à-dire dont le passage d'un état passant pour les rayonnements électromagnétiques à un état bloquant pour ces rayonnements est automatique à partir du dépassement d'un seuil d"énergie électromagnétique incidente donné et retournant à l'état passant lorsque l'énergie électromagnétique repasse sous ledit seuil. Pour ce faire la présente divulgation propose un dispositif qui comporte comme représenté en figure 1B un écran de blindage réalisé sur une optique ou un hublot transparent à la lumière au moyen d'un maillage micrométrique électriquement conducteur 2 entouré par un cadre 3 réalisé par des bordures en matériau à transition isolant-métal tel que les matériaux VO₂ , V₂O₃, BaVS₃, PrNiO₃, NdNiO₃, Fe₃O₄, NiS, LaCoO₃, SmNiO₃, NbO₂, La_{5/3}Sr_{1/3}NiO₄, Ti₂O₃, GeTe, Ge₂Sb₂Te₅ (matériaux purs ou dopés ou en solution solide, sans que cette liste soit exhaustive) comportant un moyen d'augmenter la température de rubans en matériau à transition isolant-métal formant des bordures constituant ledit cadre en présence d'une agression électromagnétique externe jusqu'à les rendre électriquement conductrices pour une énergie électromagnétique supérieure à un seuil donné.

Selon le présent dispositif :
a. - Lorsque les bordures du matériau à transition isolant-métal sont dans l'état électriquement isolant (dit état OFF), par exemple pour une température θ_{VO2} inférieure à 67°C pour un matériau VO₂, le maillage électriquement conducteur à pas micrométrique central présente une impédance de contact élevée entre le pourtour de l'écran et la masse du système à protéger. L'efficacité de blindage est donc minimale ;
b. - Lorsque les bordures du matériau à transition isolant-métal sont dans l'état électriquement conducteur (dit état ON) lorsque la température θ_{VO2} est supérieure à 67°C, le maillage électriquement conducteur à pas micrométrique central présente une faible impédance de contact entre le pourtour de l'écran et la masse du système à protéger. L'efficacité de blindage est alors maximale.

Le maillage est ainsi un maillage de blindage RF commutable à pas micrométrique qui est raccordé avec une faible impédance de contact ou non à une masse d'un équipement selon la température des rubans en matériau à transition isolant-métal formant les bordures du cadre.

Pour actionner la transition du matériau isolant-métal, le présent dispositif utilise un élément suscepteur 5, disposé en regard dudit matériau à transition isolant-métal, voire en contact avec ce matériau, et adapté à transformer une énergie électromagnétique incidente en chaleur d'activation dudit matériau à transition isolant-métal. L'élément suscepteur est dimensionné et positionné pour provoquer un passage à l'état conducteur dudit matériau à transition isolant-métal sous l'action d'une énergie électromagnétique supérieure à un seuil donné en sorte de relier électriquement à faible impédance ledit maillage audit entourage électriquement conducteur lorsque l'énergie électromagnétique incidente dépasse ce seuil donné.

Dans l'ensemble de la demande, les termes « en regard » signifient que le matériau suscepteur se trouve aligné avec le matériau à transition isolant-métal selon une direction perpendiculaire au plan du hublot.

Dans le cas des figures 1A et 1B, qui représentent schématiquement une solution préférée, le maillage de blindage RF commutable 2 et le matériau à transition isolant-métal 3 sont disposés sur une face de ladite optique ou dudit hublot interne à l'équipement, tandis que l'élément suscepteur 5, est disposé sur une face externe de ladite optique ou dudit hublot 1 et comporte une couche de matériau conducteur formant un cadre en regard de la surface du cadre formé par le matériau à transition isolant-métal 3. La chaleur générée par l'élément suscepteur en présence d'une énergie électromagnétique traverse l'optique 1, par exemple un hublot en saphir et chauffe le cadre en matériau à transition isolant-métal qui, si la quantité de chaleur est suffisante, passe à l'état conducteur.

A titre d'exemple, un essai a été réalisé avec un hublot constitué d'un substrat de saphir de 0,5 mm d'épaisseur et de dimensions 50 mm par 50 mm sur lequel est déposé :
a. - en face avant: un cadre évidé en son centre fabriqué à partir d'une couche ultramince d'or de 5 nanomètres d'épaisseur et formant une bordure d'une largeur de 7 mm pour réaliser le matériau suscepteur 5 autour d'une zone transparente du hublot ;
b. - en face arrière : un cadre 3 fabriqué à partir d'une couche mince de VO₂ de 1,5 micromètre d'épaisseur formant une bordure de largeur égale à 3 mm. Le cadre VO₂ est en contact sur son bord extérieur avec un cadre conducteur 4 constitué d'une bicouche titane/argent (Ti/Ag) de 2,5 mm de large et raccordant le cadre 3 à un entourage conducteur électrique de l'équipement. Le cadre VO₂ est relié sur son bord intérieur à un carré maillé à pas micrométrique constitué d'une bicouche titane/argent (Ti/Ag) de largeur de rubans égale à 10 micromètres, de pas ou période égal à 200 micromètres et d'épaisseur 5 nanomètres/ 2 micromètres et de longueur de côté égale à 40 mm qui forme le maillage de blindage RF commutable 2.

Lorsque le cadre en matériau VO₂ est dans l'état électriquement isolant (état OFF à température inférieure à 67°C), l'efficacité de blindage est égale à environ 15 dB dans la bande fréquentielle 2 GHz - 18 GHz. Lorsque le cadre en matériau VO₂ est dans l'état électriquement conducteur (état ON à température supérieure à 67°C), alors l'efficacité de blindage est égale à environ 25 dB dans la bande fréquentielle 2 GHz - 18 GHz. La transparence optique de l'écran dans le domaine du visible (de 400 nm à 800 nm) reste supérieure à 77% quel que soit l'état OFF ou ON du cadre en matériau VO₂.

Le cadre en matériau VO₂ a selon l'exemple une épaisseur de l'ordre de 1000 à 2000 nanomètres et préférablement une épaisseur de l'ordre de 1400 nanomètres à 1600 nanomètres, cette épaisseur pouvant être choisie différente si un autre matériau à transition isolant-métal est choisi.

Un essai en chambre réverbérante réalisé selon la méthode décrite dans le document C. L. Holloway, D. A. Hill, J. Ladbury, G. Koepke, and R. Garzia, "Shielding effectiveness measurements of materials using nested reverberation chambers," IEEE Trans. Electromagn. Compat., vol. 45, no. 2, pp. 350-356, May 2003. doi: 10.1109/TEMC.2003.809117 a permis de démontrer expérimentalement que des couches ultraminces d'or (5 nm à 10 nm d'épaisseur) soumises à une contrainte électromagnétique sur une bande de fréquences de 2,7 GHz à 3,2 GHz et de puissance de 55 W en sortie d'amplificateur permettent de faire passer la température du substrat de saphir d'une valeur 22 °C à une valeur supérieure à 110 °C.

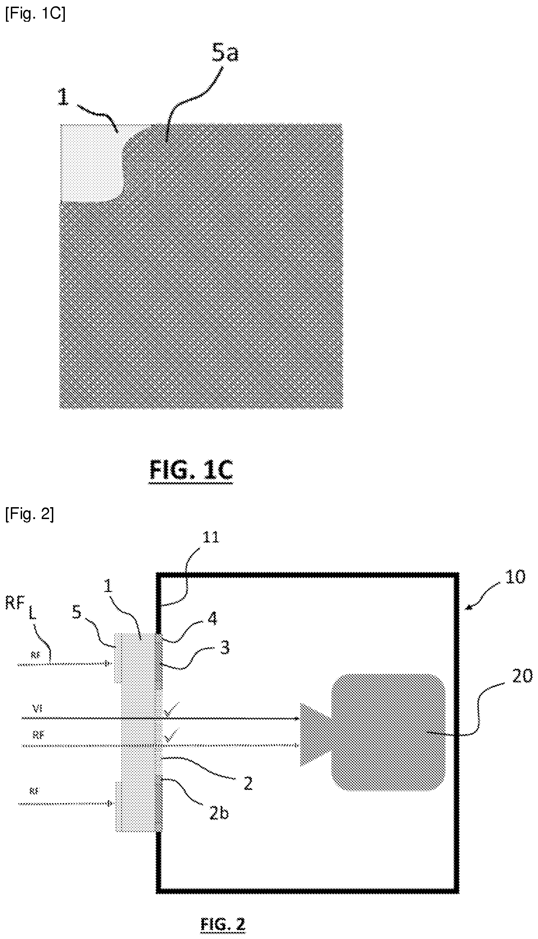

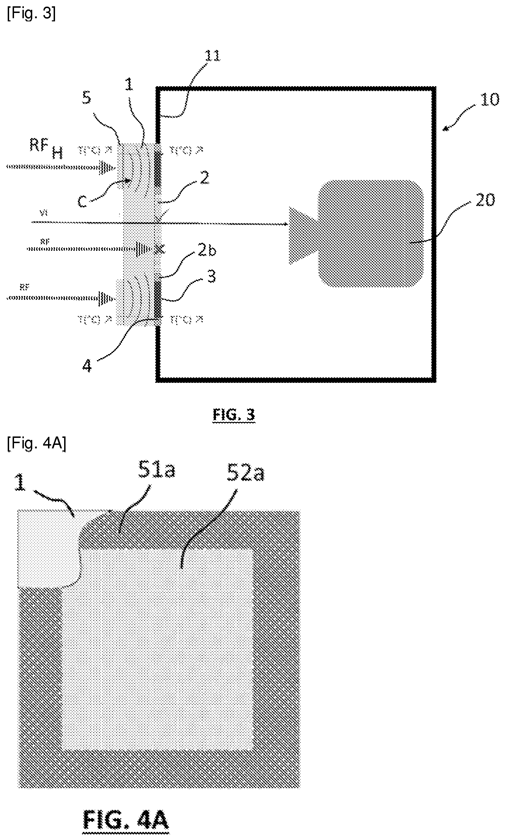

Les figure 2 et figure 3 schématisent un équipement comportant une enceinte électriquement conductrice, dans le cas présent : métallique 10 renfermant un capteur optique ou RF 20 face à une optique ou hublot 1 portant le dispositif de blindage tel que décrit aux figures 1 et 2 dont le matériau à transition isolant-métal est par exemple le matériau VO₂.

L'enceinte métallique 10 est pourvue d'un entourage métallique 11 du hublot saphir 1 et qui est raccordé électriquement au cadre conducteur 4 qui entoure le cadre 3 en matériau VO₂. Ce cadre entoure le maillage de blindage RF commutable 2 qui est ici lui-même pourvu d'une bordure 2b de raccordement électrique avec le cadre VO₂ sur la face interne du hublot.

Dans la configuration de la figure 2, un rayonnement RF_{L} de faible énergie irradie la face externe du hublot et le cadre 5 formant l'élément suscepteur. Dans cette configuration, la température du matériau à transition isolant-métal reste basse et ce dernier reste isolant électrique.

Les signaux RF et de lumière ultraviolet, visible et infrarouge VI traversent le hublot et sont reçus par le capteur 20.

En figure 3, des signaux RF_{H} de forte énergie irradient l'élément suscepteur dont la température s'élève. La quantité de chaleur C créée se transmet au travers du hublot vers le matériau à transition isolant-métal dont la température croît jusqu'à atteindre la température de transition si l'énergie du rayonnement électromagnétique est suffisante. Une fois la température de transition atteinte, le matériau à transition isolant-métal devient conducteur, ce qui permet un contact électrique à faible impédance entre le maillage 2 et l'enceinte 10 et bloque les signaux RF alors que les signaux en lumière ultraviolet, visible et infrarouge VI peuvent toujours atteindre le capteur 20.

La figure 1C correspond à une variante de la figure 1A pour laquelle la face externe du substrat en saphir formant le hublot 1 est intégralement recouverte d'une couche mince ultrafine du matériau suscepteur 5a, par exemple une couche d'or de 2 à 10 nanomètres et préférablement de 4 à 6 nanomètres pour un hublot de faible épaisseur comme décrit précédemment, tandis que la face interne du hublot reste dans la même configuration que celle de la figure 1B. Ce mode de réalisation accroît l'énergie électromagnétique captée par l'écran lorsqu'il est soumis à l'agression électromagnétique externe, et donc réduit l'énergie électromagnétique nécessaire pour obtenir une élévation de température suffisante pour provoquer la transition conductrice du matériau isolant-métal. Toutefois ce mode de réalisation diminue la transparence optique du blindage, la transparence optique maximale d'une couche mince d'or de 5 nanomètres d'épaisseur sur saphir étant proche de 50% dans le domaine du visible.

Dans le cas où le matériau à transition isolant-métal est un autre matériau que le matériau VO₂ où selon l'énergie du signal RF pour laquelle on souhaite déclencher la transition, il est possible d'accroitre ou de réduire la surface couverte par l'élément suscepteur.

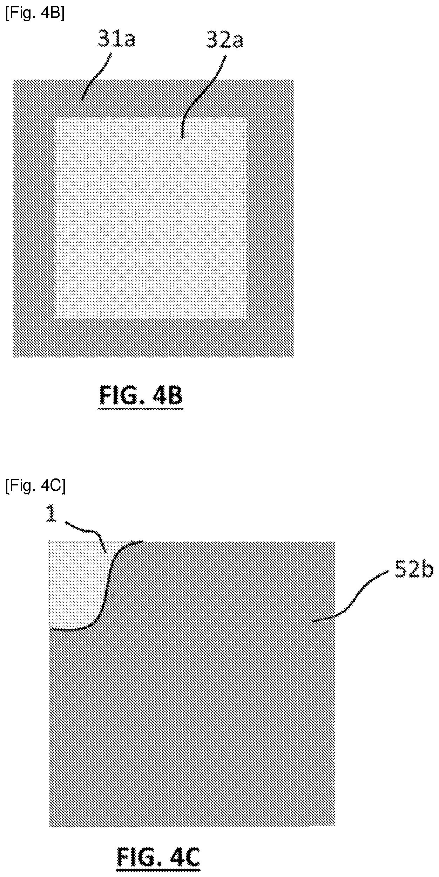

Figure 4A, figure 4B et figure 4C sont d'autres variantes avec un maillage conducteur électrique à pas micrométrique 32a intégralement en matériau à transition isolant-métal en face arrière du substrat de saphir 1 entouré par un cadre 31a de connexion à l'entourage électriquement conducteur 11 de la figure 2 lui-même en matériau à transition isolant-métal, par exemple VO₂ ou autre matériau à transition isolant-métal comme énoncé précédemment. Une efficacité de blindage assez faible est obtenue lorsque le matériau VO₂ est dans l'état électriquement conducteur, environ 10 dB dans la bande 2 GHz - 18 GHz, car sa conductivité électrique (σ = 3×10⁵ S/m environ) est plus faible que celle de l'argent (σ = 6,1×10⁷ S/m). Néanmoins, le procédé de fabrication est simplifié en raison de l'absence de la bicouche Ti/Ag maillée à pas micrométrique. Pour la face externe, la figure 4A prévoit un cadre 51a formé par une couche ultramince d'or d'épaisseur 4 à 6 nanomètres et une partie interne au cadre formée par une couche ultramince d'or maillée 52a. Dans le cas d'un hublot 1 de petite surface, la couche ultramince d'or maillée 52a pourra être supprimée, le cadre 51a étant suffisant pour apporter la quantité de chaleur nécessaire à la transition isolant-métal du maillage 32a et du cadre 31a en matériau VO₂. La figure 4C prévoit de recouvrir la totalité de la face externe du hublot 1 d'une couche ultramince continue d'or 52b qui assure une meilleure élévation de la température du hublot 1 au détriment toutefois de sa transparence optique.

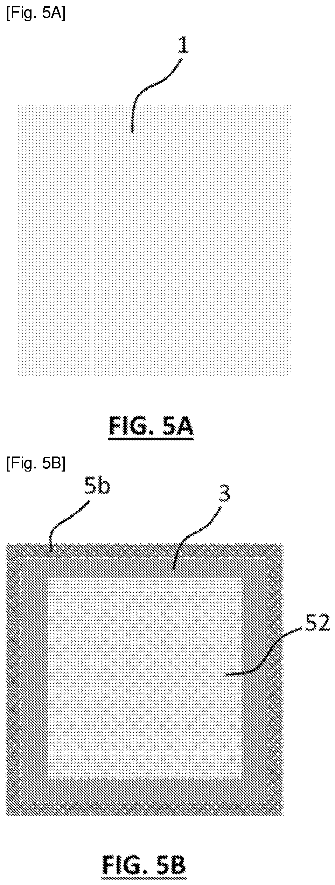

L'exemple de réalisation des figure 5A et figure 5B substitue le maillage en bicouche Ti/Ag par un maillage 52 à pas micrométrique ultramince en or d'environ 5 nanomètres d'épaisseur. Le cadre conducteur électrique entourant le cadre en matériau VO₂ 3 est remplacé par un cadre en or réalisant un matériau suscepteur directement en contact électrique avec le cadre VO₂. Ceci simplifie la fabrication de l'écran et laisse la face externe du hublot 1 nue. Néanmoins l'efficacité de blindage d'une telle couche ultramince d'or, 30 dB environ dans la bande 2 GHz - 18 GHz, est plus faible que celle de la couche Ti/Ag d'épaisseur 5 nm/2 µm maillée à pas micrométrique qui est de l'ordre de 30 à 40 dB environ dans la bande 2 GHz - 18 GHz.

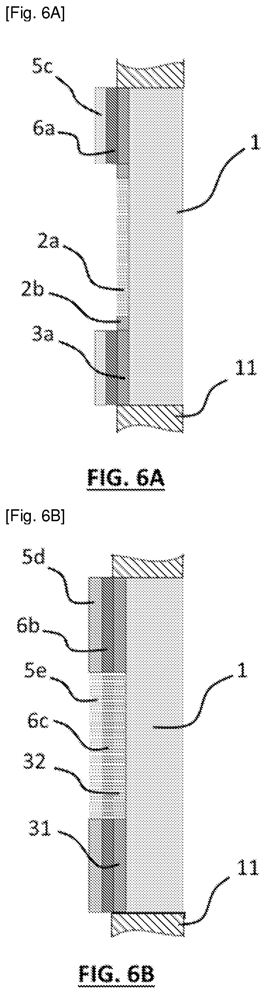

Figure 6A et figure 6B sont des variantes où seule la face externe du hublot 1 est structurée. Ces réalisations reposent sur un empilement en face externe du hublot d'un premier cadre comportant un matériau suscepteur 5c, 5d, d'un cadre de matériau électrique isolant 6a, 6b tel que TiO₂ ou Al₂O₃ d'une centaine de nanomètres d'épaisseur et d'un cadre de matériau à transition isolant-métal 3a, 31 autour d'un maillage conducteur 2a, ou à transition isolant-métal 32. Dans le cas de la figure 6A où le maillage est un maillage Ti/Ag comme en figure 1, les performances en efficacité de blindage et en transparence optique de l'écran sont conservées avec, en sus, une amélioration de la vitesse de commutation entre les états ON et OFF, car la quantité de chaleur générée par la couche de matériau suscepteur lors de l'agression EM externe doit seulement traverser la couche mince de TiO₂ ou de Al₂O₃, et non plus le hublot, qui est beaucoup plus épais.

La fabrication de ces variantes est néanmoins plus complexe en raison de la nécessité d'utiliser une nouvelle couche tampon diélectrique 6a, 6b dotée d'une conductivité thermique élevée, par exemple en matériau TiO₂ ou Al₂O₄ d'une épaisseur de l'ordre de 100 nanomètres par exemple. Cette couche diélectrique tampon de TiO₂ ou de Al₂O₄ doit être intercalée entre la couche ultramince d'or et la couche de VO₂. Lorsque la couche ultramince d'or convertit l'énergie de l'onde électromagnétique en quantité de chaleur, cette dernière est transférée à la couche mince de VO₂ au travers de la couche tampon et provoque la transition isolant/métal du matériau VO₂. Néanmoins, cette couche d'or doit rester électriquement isolée de la couche de VO₂, afin qu'elle conserve toutes ses capacités de suscepteur.

Dans le cas de la figure 6B, le maillage Ti/Ag est remplacé un maillage VO₂ 32 relié au cadre VO₂ 31 et les couches isolante et d'or sont elles-mêmes pourvues de maillages 6c et 5e, respectivement.

La présente divulgation ne se limite pas aux exemples décrits ci-avant, seulement à titre d'exemple, mais elle englobe toutes les variantes que pourra envisager l'homme de l'art dans le cadre de la protection recherchée. Notamment, les diverses solutions décrites peuvent être panachées comme la solution des figures 5A et 5B notamment pour laquelle le maillage en or peut être remplacé par un maillage Ti/Ag de la solution de la figure 1B. De même les épaisseurs et les dimensions latérales annoncées ci-dessus le sont à titre indicatif et peuvent varier en fonction du niveau d'énergie de rayonnement électromagnétique auquel l'autoadaptation du blindage est souhaitée et des dimensions du hublot.

La gamme de fréquence de protection recherchée contre les agressions EM externes à base de maillage électriquement conducteur à pas micrométrique de la présente divulgation couvre la bande 0,1 GHz à 40 GHz. Un pas de maillage de dimension millimétrique, voire centimétrique pourra aussi être envisagé, néanmoins au détriment de la fréquence haute de protection dudit écran de blindage.

L'invention n'est pas limitée aux exemples décrits ci-avant et notamment d'autres combinaisons pour l'implantation des matériaux sont possibles du moment que le matériau suscepteur est positionné en sorte de pouvoir chauffer, en présence d'une énergie électromagnétique donnée, le matériau à transition isolant-métal lui-même positionné pour permettre de relier le blindage RF commutable à un entourage conducteur électrique d'une optique ou d'un hublot. Il est en outre possible dans le cadre de la présente divulgation de substituer le film ou couche ultramince d'or utilisée comme suscepteur par une couche de graphite, d'acier inoxydable, de molybdène, ou de carbure de silicium, ou encore d'aluminium, sans que cette liste soit exhaustive. Il est en outre possible dans le cadre de la présente divulgation de remplacer le maillage métallique par un matériau en couche mince continue ou maillée appartenant à la famille des oxydes transparents et conducteurs (OTC) tel que In₂O₃ pur ou dopé (ITO, FTO, ...) ; ZnO pur ou dopé (AZO, ...) sans que cette liste soit exhaustive.

## Revendications

1. Dispositif de blindage électromagnétique auto-adaptatif optiquement transparent d'une optique ou d'un hublot (1) d'un équipement pourvu d'une enceinte électriquement conductrice (10) renfermant un capteur optique ou RF (20) derrière ladite optique ou ledit hublot, ledit dispositif comportant sur au moins une face de ladite optique ou dudit hublot un écran de blindage comportant un maillage de blindage RF commutable (2, 2a, 32, 32a, 52, 52a) au moins partiellement entouré par une bordure de matériau à transition isolant-métal (3, 3a, 31, 31a) disposée entre ledit maillage et un entourage électriquement conducteur (11) de blindage dudit équipement, **caractérisé en ce qu'**il comporte un élément suscepteur (5, 5a, 5b, 5c, 5d, 5e, 51a, 52b), disposé en regard du ou en contact avec ledit matériau à transition isolant-métal et adapté à transformer une énergie électromagnétique incidente (RF_{H}) en quantité de chaleur d'activation dudit matériau à transition isolant-métal (3, 3a, 31, 31a), ledit élément suscepteur étant dimensionné pour provoquer un passage à l'état conducteur dudit matériau à transition isolant-métal (3, 3a, 31, 31a, 32, 32a) sous l'action de ladite énergie électromagnétique en sorte de relier électriquement à basse impédance ledit maillage audit entourage électriquement conducteur lorsque l'énergie électromagnétique incidente dépasse un seuil donné.

2. Dispositif de blindage auto-adaptatif selon la revendication 1, pour lequel le maillage de blindage RF commutable (2) et le matériau à transition isolant-métal (3) sont disposés sur une face de ladite optique ou dudit hublot interne à l'équipement tandis que l'élément suscepteur (5, 5a) est réalisé sur une face externe de ladite optique ou dudit hublot (1) et comporte une couche de matériau électriquement conducteur en regard d'une surface dudit matériau à transition isolant-métal.

3. Dispositif de blindage auto-adaptatif selon la revendication 2, pour lequel le matériau à transition isolant-métal forme un premier cadre (3) autour du maillage, l'élément suscepteur étant conformé en second cadre (5) en regard dudit premier cadre.

4. Dispositif de blindage auto-adaptatif selon la revendication 3, pour lequel une surface du second cadre (5) est supérieure ou égale à une surface du premier cadre.

5. Dispositif de blindage auto-adaptatif selon la revendication 2, pour lequel l'élément suscepteur comporte une couche de matériau conducteur (5a) semi-transparente recouvrant la face externe de ladite optique ou dudit hublot (1).

6. Dispositif de blindage auto-adaptatif selon la revendication 1, pour lequel le maillage de blindage RF commutable (2a) et le matériau à transition isolant-métal (3a) sont déposés sur une face externe de ladite optique ou dudit hublot, l'élément suscepteur comportant une couche de matériau conducteur (5c) en regard d'une surface dudit matériau à transition isolant-métal et déposée sur une couche électriquement isolante (6a) recouvrant ledit matériau à transition isolant-métal.

7. Dispositif de blindage selon la revendication 1 pour lequel le maillage de blindage RF commutable (52), le matériau à transition isolant-métal (3) et l'élément suscepteur (5b) sont disposés sur une face de ladite optique ou dudit hublot interne ou externe à l'équipement, l'élément suscepteur (5b) étant réalisé sous la forme d'un cadre entourant le matériau à transition isolant-métal, ce dernier entourant le maillage de blindage RF commutable.

8. Dispositif de blindage auto-adaptatif selon la revendication 6, pour lequel le maillage de blindage RF commutable (32) est réalisé avec le matériau à transition isolant-métal déposé sur une face externe de ladite optique ou dudit hublot et recouvrant ladite face externe, l'élément suscepteur comportant une couche de matériau conducteur (5e) déposé sur une couche isolante (6b, 6c) recouvrant elle-même ledit matériau à transition isolant-métal.

9. Dispositif de blindage auto-adaptatif selon la revendication 8, pour lequel ladite couche de matériau conducteur et/ou ladite couche de matériau isolant comportent un maillage optiquement transparent recouvrant le maillage de blindage RF commutable.

10. Dispositif de blindage auto-adaptatif selon l'une quelconque des revendications précédentes, pour lequel le maillage de blindage RF commutable est un maillage à pas micrométrique en matériau électriquement conducteur.

11. Dispositif de blindage auto-adaptatif selon l'une quelconque des revendications précédentes, pour lequel le maillage de blindage RF commutable est un maillage en matériau choisi parmi un bicouche titane/argent, un matériau à transition isolant-métal ou l'or.

12. Dispositif de blindage auto-adaptatif selon l'une quelconque des revendications précédentes, pour lequel le matériau à transition isolant-métal est un matériau de type VO₂d'épaisseur entre 1000 nm et 2000 nm.

13. Dispositif de blindage auto-adaptatif selon l'une quelconque des revendications précédentes, pour lequel l'élément suscepteur est un film d'or d'épaisseur de 2 nanomètres à 10 nanomètres.

14. Dispositif de blindage auto-adaptatif selon l'une quelconque des revendications précédentes, pour lequel le maillage de blindage RF commutable (2, 2a, 32, 32a, 52, 52a) est dimensionné pour fournir une efficacité de blindage de 10 dB à 40 dB dans une bande de fréquence de 0,1 GHz à 40 GHz lorsqu'il est raccordé électriquement à basse impédance à l'entourage conducteur électrique (11) par le matériau à transition isolant-métal rendu conducteur.

15. Dispositif de blindage auto-adaptatif selon l'une quelconque des revendications précédentes, pour lequel la transparence optique de l'écran de blindage est d'au moins 50% dans le domaine du visible.

## Patentansprüche

1. Optisch transparente, selbstanpassende Vorrichtung zur elektromagnetischen Abschirmung einer Optik oder Sichtscheibe (1) einer Einrichtung mit einer elektrisch leitenden Umhüllung (10), die einen optischen oder HF-Sensor (20) hinter der Optik oder Sichtscheibe umschließt, wobei die Vorrichtung auf zumindest einer Seite der Optik oder Sichtscheibe eine Abschirmblende mit einem schaltbaren HF-Abschirmgeflecht (2, 2a, 32, 32a, 52, 52a) umfasst, das zumindest teilweise von einer Umrandung aus einem Isolator-Metall-Übergangsmaterial (3, 3a, 31, 31a) umgeben ist, die zwischen dem Geflecht und einer elektrisch leitenden Umgebung (11) zur Abschirmung der Einrichtung angeordnet ist,
**dadurch gekennzeichnet, dass** sie ein Suszeptorelement (5, 5a, 5b, 5c, 5d, 5e, 51a, 52b) enthält, das gegenüber dem oder in Kontakt mit dem Isolator-Metall-Übergangsmaterial angeordnet und dazu geeignet ist, eine einfallende elektromagnetische Energie (RF_{H}) in eine Wärmemenge zur Aktivierung des Isolator-Metall-Übergangsmaterials (3, 3a, 31, 31a) umzuwandeln, wobei das Suszeptorelement so bemessen ist, dass es einen Übergang des Isolator-Metall-Übergangsmaterials (3, 3a, 31, 31a, 32, 32a) in den leitenden Zustand unter der Wirkung der elektromagnetischen Energie bewirkt, so dass das Geflecht mit der elektrisch leitenden Umgebung niederohmig elektrisch verbunden wird, wenn die einfallende elektromagnetische Energie einen gegebenen Schwellenwert überschreitet.

2. Selbstanpassende Abschirmungsvorrichtung nach Anspruch 1,
wobei das schaltbare HF-Abschirmgeflecht (2) und das Isolator-Metall-Übergangsmaterial (3) auf einer Seite der Optik oder Sichtscheibe innerhalb der Einrichtung angeordnet sind, während das Suszeptorelement (5, 5a) auf einer Außenseite der Optik oder Sichtscheibe (1) ausgebildet ist und eine Schicht aus elektrisch leitendem Material umfasst, die einer Oberfläche des Isolator-Metall-Übergangsmaterials gegenüberliegt.

3. Selbstanpassende Abschirmungsvorrichtung nach Anspruch 2,
wobei das Isolator-Metall-Übergangsmaterial einen ersten Rahmen (3) um das Geflecht herum bildet, wobei das Suszeptorelement als dem ersten Rahmen gegenüberliegender zweiter Rahmen (5) ausgebildet ist.

4. Selbstanpassende Abschirmungsvorrichtung nach Anspruch 3,
wobei eine Oberfläche des zweiten Rahmens (5) größer oder gleich einer Oberfläche des ersten Rahmens ist.

5. Selbstanpassende Abschirmungsvorrichtung nach Anspruch 2,
wobei das Suszeptorelement eine halbtransparente Schicht aus leitendem Material (5a) umfasst, die die Außenseite der Optik oder Sichtscheibe (1) bedeckt.

6. Selbstanpassende Abschirmungsvorrichtung nach Anspruch 1,
wobei das schaltbare HF-Abschirmgeflecht (2a) und das Isolator-Metall-Übergangsmaterial (3a) auf einer Außenseite der Optik oder Sichtscheibe aufgebracht sind, wobei das Suszeptorelement eine Schicht aus leitendem Material (5c) umfasst, die einer Oberfläche des Isolator-Metall-Übergangsmaterials gegenüberliegt und auf einer elektrisch isolierenden Schicht (6a) aufgebracht ist, die das Isolator-Metall-Übergangsmaterial bedeckt.

7. Abschirmungsvorrichtung nach Anspruch 1,
wobei das schaltbare HF-Abschirmgeflecht (52), das Isolator-Metall-Übergangsmaterial (3) und das Suszeptorelement (5b) auf einer Seite der Optik oder Sichtscheibe innerhalb oder außerhalb der Einrichtung angeordnet sind, wobei das Suszeptorelement (5b) als Rahmen ausgeführt ist, der das Isolator-Metall-Übergangsmaterial umgibt, wobei letzteres das schaltbare HF-Abschirmgeflecht umgibt.

8. Selbstanpassende Abschirmungsvorrichtung nach Anspruch 6,
wobei das schaltbare HF-Abschirmgeflecht (32) mit dem Isolator-Metall-Übergangsmaterial ausgebildet ist, das auf einer Außenseite der Optik oder Sichtscheibe aufgebracht ist und die Außenseite bedeckt, wobei das Suszeptorelement eine Schicht aus leitendem Material (5e) umfasst, das auf einer Isolierschicht (6b, 6c) aufgebracht ist, die ihrerseits das Isolator-Metall-Übergangsmaterial bedeckt.

9. Selbstanpassende Abschirmungsvorrichtung nach Anspruch 8,
wobei die Schicht aus leitendem Material und/oder die Schicht aus isolierendem Material ein optisch transparentes Geflecht umfasst, das das schaltbare HF-Abschirmgeflecht bedeckt.

10. Selbstanpassende Abschirmungsvorrichtung nach einem der vorhergehenden Ansprüche,
wobei das schaltbare HF-Abschirmgeflecht ein Geflecht aus elektrisch leitendem Material mit Mikrometermaschenweite ist.

11. Selbstanpassende Abschirmungsvorrichtung nach einem der vorhergehenden Ansprüche,
wobei das schaltbare HF-Abschirmgeflecht ein Geflecht aus einem Material ist, das aus einer Titan/Silber-Doppelschicht, einem Isolator-Metall-Übergangsmaterial oder Gold ausgewählt ist.

12. Selbstanpassende Abschirmungsvorrichtung nach einem der vorhergehenden Ansprüche,
wobei das Isolator-Metall-Übergangsmaterial ein VO₂ -Material mit einer Dicke zwischen 1000 nm und 2000 nm ist.

13. Selbstanpassende Abschirmungsvorrichtung nach einem der vorhergehenden Ansprüche,
wobei das Suszeptorelement eine Goldfolie mit einer Dicke zwischen 2 Nanometern und 10 Nanometern ist.

14. Selbstanpassende Abschirmungsvorrichtung nach einem der vorhergehenden Ansprüche,
wobei das schaltbare HF-Abschirmgeflecht (2, 2a, 32, 32a, 52, 52a) so bemessen ist, dass es eine Abschirmungseffizienz von 10 dB bis 40 dB in einem Frequenzband von 0,1 GHz bis 40 GHz bereitstellt, wenn es durch das leitfähig gemachte Isolator-Metall-Übergangsmaterial mit der elektrisch leitenden Umgebung (11) niederohmig elektrisch verbunden ist.

15. Selbstanpassende Abschirmungsvorrichtung nach einem der vorhergehenden Ansprüche,
wobei die optische Transparenz der Abschirmblende im sichtbaren Bereich zumindest 50 % beträgt.

## Claims

1. Optically transparent self-adaptive electromagnetic shielding device for a lens or for a window (1) of a piece of equipment provided with an electrically conductive enclosure (10) containing an optical or RF sensor (20) behind said lens or said window, said device comprising, on at least one face of said lens or said window, a shielding screen comprising a switchable RF shielding mesh (2, 2a, 32, 32a, 52, 52a) at least partially surrounded by a border of insulator-metal transition material (3, 3a, 31, 31a) arranged between said mesh and an electrically conductive envelope (11) for shielding said piece of equipment, **characterized in that** it comprises a susceptor element (5, 5a, 5b, 5c, 5d, 5e, 51a, 52b) arranged facing or in contact with said insulator-metal transition material and adapted to transform incident electromagnetic energy (RF_{H}) into an amount of activation heat for said insulator-metal transition material (3, 3a, 31, 31a), said susceptor element being dimensioned to cause a transition to the conductive state of said insulator-metal transition material (3, 3a, 31, 31a, 32, 32a) under the action of said electromagnetic energy so as to electrically connect, at low impedance, said mesh to said electrically conductive envelope when the incident electromagnetic energy exceeds a given threshold.

2. Self-adaptive shielding device according to claim 1, wherein the switchable RF shielding mesh (2) and the insulator-metal transition material (3) are arranged on one face of said lens or of said window, internal to the piece of equipment, while the susceptor element (5, 5a) is implemented on an external face of said lens or of said window (1) and comprises a layer of electrically conductive material which faces a surface of said insulator-metal transition material.

3. Self-adaptive shielding device according to claim 2, wherein the insulator-metal transition material forms a first frame (3) around the mesh, the susceptor element being shaped as a second frame (5) facing said first frame.

4. Self-adaptive shielding device according to claim 3, wherein a surface area of the second frame (5) is greater than or equal to a surface area of the first frame.

5. Self-adaptive shielding device according to claim 2, wherein the susceptor element comprises a layer of semi-transparent conductive material (5a) covering the external face of said lens or of said window (1).

6. Self-adaptive shielding device according to claim 1, wherein the switchable RF shielding mesh (2a) and the insulator-metal transition material (3a) are deposited on an external face of said lens or of said window, the susceptor element comprising a layer of conductive material (5c) facing a surface of said insulator-metal transition material and deposited on an electrically insulating layer (6a) covering said insulator-metal transition material.

7. Shielding device according to claim 1, wherein the switchable RF shielding mesh (52), the insulator-metal transition material (3), and the susceptor element (5b) are arranged on one face of said lens or of said window, internal or external to the piece of equipment, the susceptor element (5b) being implemented in the form of a frame surrounding the insulator-metal transition material, the latter surrounding the switchable RF shielding mesh.

8. Self-adaptive shielding device according to claim 6, wherein the switchable RF shielding mesh (32) is implemented with the insulator-metal transition material deposited on an external face of said lens or of said window and covering said external face, the susceptor element comprising a layer of conductive material (5e) deposited on an insulating layer (6b, 6c) which itself covers said insulator-metal transition material.

9. Self-adaptive shielding device according to claim 8, wherein said layer of conductive material and/or said layer of insulating material comprises an optically transparent mesh covering the switchable RF shielding mesh.

10. Self-adaptive shielding device according to any one of the preceding claims, wherein the switchable RF shielding mesh is a mesh of micrometric pitch made of electrically conductive material.

11. Self-adaptive shielding device according to any one of the preceding claims, wherein the switchable RF shielding mesh is a mesh made of a material chosen among a titanium/silver bilayer, an insulator-metal transition material, or gold.

12. Self-adaptive shielding device according to any one of the preceding claims, wherein the insulator-metal transition material is a VO₂ type of material with a thickness between 1000 and 2000 nm.

13. Self-adaptive shielding device according to any one of the preceding claims, wherein the susceptor element is a gold film with a thickness of 2 nanometers to 10 nanometers.

14. Self-adaptive shielding device according to any one of the preceding claims, wherein the switchable RF shielding mesh (2, 2a, 32, 32a, 52, 52a) is dimensioned to provide a shielding effectiveness of 10 dB to 40 dB within a frequency band of 0.1 GHz to 40 GHz when it is electrically connected at low impedance to the electrically conductive envelope (11) by the insulator-metal transition material rendered conductive.

15. Self-adaptive shielding device according to any one of the preceding claims, wherein the optical transparency of the shielding screen is at least 50% in the visible range.
